# EUROPEAN PATENT APPLICATION

(11) **EP 2 189 824 A1**
(43) Date of publication of application: **26.05.2010**
(21) Application number: 08830997.6
(22) Date of filing: 10.09.2008
(51) Int. Cl.: G02B 5/02, B32B 7/02, G02B 1/11, G02F 1/1335, G09F 9/00

(54) **OPTICAL FILTER FOR DISPLAY, DISPLAY HAVING SAME, AND PLASMA DISPLAY PANEL**

(30) Priority: 13.09.2007 JP 2007237810
(71) Applicant: Bridgestone Corporation, Tokyo 104-0031 (JP)
(72) Inventor: KAMEI, Hideyuki, Yokohama-shi Kanagawa 244-8510 (JP)
(74) Representative: Whalley, Kevin
(86) International application number: PCT/JP2008/066294
(87) International publication number: WO 2009/034985

(57) **Abstract**

[Problem to be solved]

To provide an optical filter for display which has excellent antiglare properties, high transmittance and improved visibility and contrast of image.

[Means for solving problem]

An optical filter for display comprising a structure that an antiglare layer comprising a resin and fine particles dispersed therein is provided on one surface of a transparent substrate, wherein a surface of the antiglare layer has a great number of fine projections formed from the fine particles and at least some of the fine projections have a plain surface parallel to a surface of the antiglare layer other than the fine projections at their top portions.

## Description

### Field of the invention

The present invention relates to an optical filter for adding various functions such as antiglare properties to various displays such as plasma display panel (PDP), cathode-ray-tube (CRT) display, liquid crystal display, organic EL (electroluminescence) display and field emission display (FED) including surface-conduction electron-emitter display (SED), and a display, particularly PDP, provided with the optical filter.

### Description of the Related Art

In flat-panel displays such as liquid crystal display, plasma display panel (PDP) and organic EL display, and CRT display, the problem that external light is reflected on a surface of the display to have difficulty seeing visual information of the display has been known. Therefore, various countermeasures including provision of various optical films such as an antiglare layer and antireflection film on the displays are taken.

In recent years, image magnification has entered the mainstream of the displays, and use of PDP and liquid crystal display have been generalized. In case the large-scaled display is used in a room, not only light of a illumination such as a fluorescent lamp reflects and scatters on the surface of the display to give glare to audience, but also the light comes out the surface of the display to render reorganization of character or the like difficult. Therefore it is necessary to provide the display with high antiglare properties to prevent the occurrence of glare by exterior environment and the occurrence of image by reflection (phenomenon that image appears on the display surface). As the optical filter having the antiglare properties, for example, filters obtained by coating resin containing filler such as silicon dioxide (silica) on a transparent base film has been proposed (Patent Documents 1 and 2). Any of the filters acquire light diffusion and antiglare functions by concavo-convex shape formed on the surface of the antiglare layer. In order to enhance the antiglare function, it is necessary to enlarge the size of the concavo-convex shape. However, the enlargement of the size of the concavo-convex shape brings about increase of haze value of the antiglare layer and hence reduction of definition (visibility) of transparent image.

As an antiglare film (optical filter) improved in definition of transparent image without reduction of antiglare properties, for example, filters consisting of light-transmittable resin containing spherical light-transmittable particles dispersed therein has been proposed (Patent Document 3).

Patent document 1: JP6-18706-A
Patent document 2: JP 10-20103-A
Patent document 3: JP11-326608-A

### Disclosure of the Invention

### Problem to be solved by the Invention

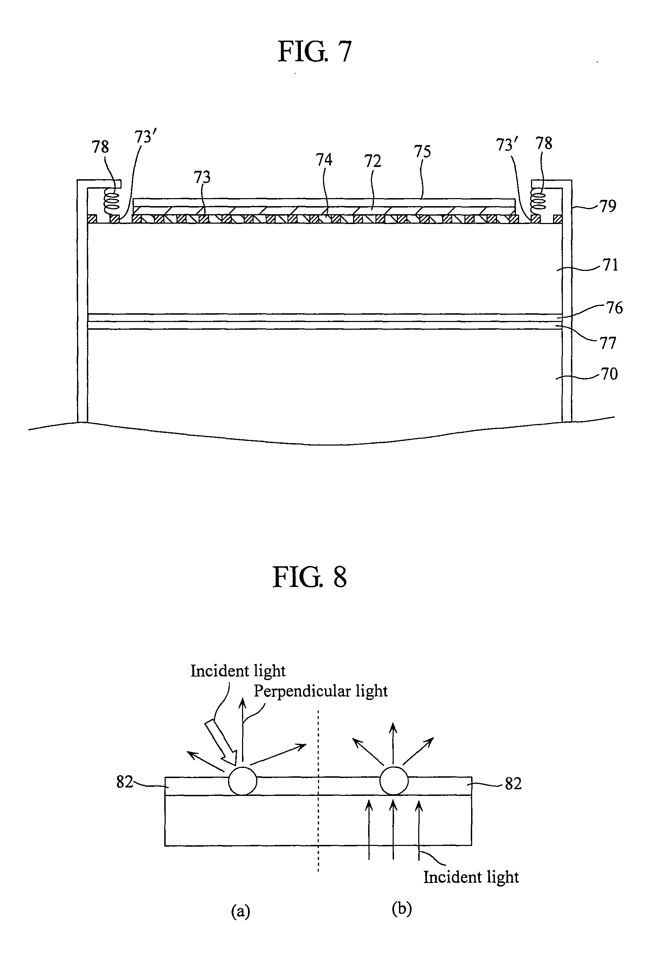

According to study of the present inventor, the use of the spherical light-transmittable particles of Patent Document 3 for enhancement of antiglare properties brings about relatively enhanced light transmittance due to transparency of the particles but increase of antiglare properties. In more detail, the shape of the projection (concave portion) of the antiglare layer is spherical and hence light incident on the antiglare layer scatters on the surface of the projection. A considerable degree of the scattered light goes straight or nearly straight, and therefore the degree of glare caused by the incident light increases. Further a part of light emitted from inside (display side) scatters on the surface of the projection to increase the degree of glare.
As shown in Fig. 8(a), incident light from outside (bold arrow) scatters on a surface of a spherical projection of an antiglare layer 82. Thus, not only the scattered light but also the reflected light perpendicular to the antiglare layer (perpendicular light) generate, which increase the degrees of the glare and the occurrence of image by reflection. Further, as shown in Fig. 8(b), a part of light emitted from inside (display side) scatters (diffuses) on the surface of the spherical projection of the antiglare layer 82 to make it difficult to bring the light to audience, which brings about the reduction of transmittance and contrast.

Further, in case an antiglare layer is formed by coating a coating liquid containing the spherical light-transmittable particles, the projection s of resultant antiglare layer are apt to hide behind the layer depending on the variation of the thickness and hence it is difficult to obtain excellent antiglare properties.

Thus, the object of the present invention is to provide an optical filter for display which has excellent antiglare properties, high transmittance and improved visibility and contrast of image.

Further, the object of the invention is to provide an optical filter for display which can be easily prepared and which has excellent antiglare properties, high transmittance and improved visibility and contrast of image

Furthermore, the object of the invention is to provide an optical filter for display, suitable for PDP, which is thin and light, which can be easily prepared, and which has excellent electromagnetic wave shielding property, excellent antiglare properties, high transmittance and improved visibility and contrast of image.

Further, the object of the present invention is to provide a display wherein the optical filter for display having excellent properties mentioned above is attached onto a surface of the glass plate for displaying image of the display.

Further, the object of the present invention is to provide a plasma display panel (PDP) wherein the optical filter for display having excellent properties mentioned above is attached onto a surface of the glass plate for displaying image of the display.

### Means for solving problem

Thus, the present invention can be provided by an optical filter for display comprising a structure that an antiglare layer comprising a resin and fine particles dispersed therein is provided on one surface of a transparent substrate (generally a transparent film),
wherein a surface of the antiglare layer has a great number of fine projections formed from the fine particles and at least some of the fine projections have a plain surface parallel to a surface of the antiglare layer other than the fine projections at their top portions.

The preferred embodiments of the optical filter for display according to the present invention are described as follows:
(1) Each of the projections is in the form of polyhedron. It is preferably in the form of hexahedron, further preferably rectangular parallelepiped, particularly cube. Thereby more excellent antiglare properties, high transmittance and improved visibility (sharpness) and contrast of image can be easily obtained.
(2) The fine projections are formed from the fine particles as mentioned above. The antiglare layer is a resin layer comprising a resin and fine particles dispersed therein, and therefore the protruded concave portion (projection) is formed from the fine particle. However, an extremely thin layer of resin generally exists on the surface of the projection.
   In general, the projection is formed from 90% or more by weight of the fine particle.
(3) The plain surface parallel to a surface of the antiglare layer other than the fine projections has sides having an average length of 0.5 to 10µm. Further the fine projections have an average height of 0.5 to 5µm. Thereby more excellent antiglare properties, high transmittance and improved visibility and contrast of image can be obtained.

The average length of the sides of the plain surface parallel to a surface of the antiglare layer other than the fine projections and the average height of the fine projections are determined from the profile curve (sectional curve) which is obtained by measuring the surface of the antiglare layer by using a surface roughness meter (Trade name: SURFCOM 480A; available from TOKYO SEIMITSU CO. LTD.) according to JIS B 0601-2001. The measured length is 2m.
(4) The antiglare layer has a thickness of 1 to 20µm. The thickness is a height from the surface of the film (transparent substrate) to the surface of the antiglare layer, and is obtained by measuring the surface of the film and the surface of the antiglare layer formed thereon by using a surface roughness meter (Trade name: SURFCOM 480A; available from TOKYO SEIMITSU CO. LTD.) according to JIS B 0601-2001 and calculating their difference.
(5) The fine particles are organic resin fine particles and/or inorganic fine particles. The organic resin fine particles are preferably at least one kind selected from cross-linked acrylic resin particles, cross-linked styrene resin particles and cross-linked (meth)acrylate-styrene copolymer particles. The inorganic fine particles are preferably at least one kind selected from calcium carbonate fine particles and silica fine particles.
(6) Each of the fine particles is in the form of polyhedron, preferably hexahedron, further preferably rectangular parallelepiped, particularly cube. Thereby the plain surfaces of the fine projections parallel to a surface of the antiglare layer other than the fine projections can be easily acquired.
(7) The fine particles have an average particle size of 0.5 to 15µm.
(8) The antiglare layer contains ultraviolet curable resin as resin.
(9) An electrically conductive layer is provided between the antiglare layer and the transparent substrate. The conductive layer is preferably a mesh-shaped conductive layer. The conductive layer has preferably a thickness of 1 to 15µm.
(10) The antiglare layer has hard coat function.
(11) The antiglare layer has a low refractive index layer having refractive index lower than that of the antiglare layer provided thereon.
(12) A near-infrared absorption layer is provided on the side opposite to the antiglare layer side of the transparent film.
(13) A transparent adhesive layer is provided on the near-infrared absorption layer. Thereby the optical filter can be easily attached to a display.
(14) A near-infrared absorption layer has neon-cutting function.
(15) The optical filter has definition (visibility) of transparent image of not less than 150, the definition being defined in JIS K 7105. In general, the measurement is carried out regarding a laminate consisting of a film and an antiglare layer, or a laminate consisting of a film, a conductive layer and an antiglare layer.
(16) The optical filter has definition (visibility) of reflected image (reflected angle: 45 degrees) of not more than 100, the definition being defined in JIS K 7105. In general, the measurement is carried out regarding a laminate consisting of a film and an antiglare layer, or a laminate consisting of a film, a conductive layer and an antiglare layer.
(17) The transparent film is a plastic film.
(18) The optical filter for display is an optical filter for plasma display panel.
(19) The optical filter for display is attached onto a glass plate.

The present invention can be provided by an optical filter for display comprising a structure that an antiglare layer comprising a resin and fine particles dispersed therein is provided on one surface of a transparent substrate,
wherein at least some of the fine particles are in the form of hexahedron.

The preferred embodiments of the optical filter for display according to the present invention are described as follows:
(1) Each of the fine particles is in the form of cube.
(2) The fine particles have an average particle size of 0.5 to 15µm.
(3) The antiglare layer contains ultraviolet curable resin as resin.
(4) An electrically conductive layer is provided between the antiglare layer and the transparent substrate.

Further, the embodiments of the present optical filter defining the shape of the projections of the antiglare layer as mentioned previously can be applied to the above-mentioned optical filter defining the shape of the fine particles.

Furthermore, the present invention can be also provided by a display provided with the optical filter for display as mentioned above; and
a plasma display panel provided with the optical filter for display as mentioned above; the optical filter being generally attached onto a surface of the glass plate for displaying image of the display.

The optical filter for display is preferably attached onto a surface of the glass plate for displaying image of the display by bonding a surface having no conductive layer of the optical filter to the surface of the glass plate.

### Effect of the Invention

The optical filter for display of the present invention has the feature that the antiglare layer is provided on the transparent substrate and has a great number of fine projections having a plain surface parallel to a surface of the antiglare layer other than the fine projections at their top portions. Hence, in case the optical filter is attached to a display, the resultant display shows excellent antiglare properties, high transmittance and improved visibility and contrast of image. In more detail, in the optical filter of the invention, incident light from outside scatters on a surface of the antiglare layer, and therefore the reflected light perpendicular to the antiglare layer scarcely generate, whereby the degrees of the glare and the occurrence of image by reflection are greatly reduced. Further, almost light emitted from inside (display side) is brought about audience whereby image enhanced in transmittance and contrast can be obtained.

Further the antiglare layer of the invention can be formed by coating a coating liquid comprising resin and fine particles in the form of polyhedron, especially hexahedron dispersed therein. By the coating, the projections can be easily formed in a desired size, and therefore it is not required to precisely control the conditions for the coating. Thus an antiglare layer having desired antiglare properties can be formed in high productivity.

Thus, the optical filter for display of the invention is excellent in antiglare properties and transparency of image displayed on a display, and is hence useful as an optical filter attached onto a surface of various displays such as plasma display panel (PDP), organic EL (electroluminescence) display.

### Brief Description of the Drawings

[Fig. 1] Fig. 1 is a partially schematic section view showing an example of a basic structure of the optical filter for display according to the present invention.
[Fig. 2] Fig. 2 is a partially enlarged section view of the optical filter for display of Fig. 1.
[Fig. 3] Fig. 3 is a schematic view showing the condition of reflection and transmission of incident light in the optical filter for display of the present invention.
[Fig. 4] Fig. 4 is a partially schematic section view showing an example of preferred embodiments of the optical filter for display according to the present invention.
[Fig. 5] Fig. 5 is a partially schematic section view showing another example of preferred embodiments of the optical filter for display according to the present invention.
[Fig. 6] Fig. 6 is a partially schematic section view showing another example of preferred embodiments of the optical filter for display according to the present invention.
[Fig. 7] Fig. 7 is a schematic section view showing an example of a plasma display panel as display onto which the optical filter for display of the present invention is attached.
[Fig. 8] Fig. 8 is a schematic view showing the condition of reflection and transmission of incident light in a conventional optical filter for display.

### Explanation of reference number

11, 41, 51, 61 Transparent film
12, 42, 52, 62 Antiglare layer
43, 53, 63 Conductive layer
54, 64 Sealing layer
55, 65 Low refractive index layer
66, 76 Near-infrared absorption layer
67, 77 Transparent adhesive layer

### Description of Preferred Embodiments

The optical filter for display according to the present invention is explained with reference to drawings.

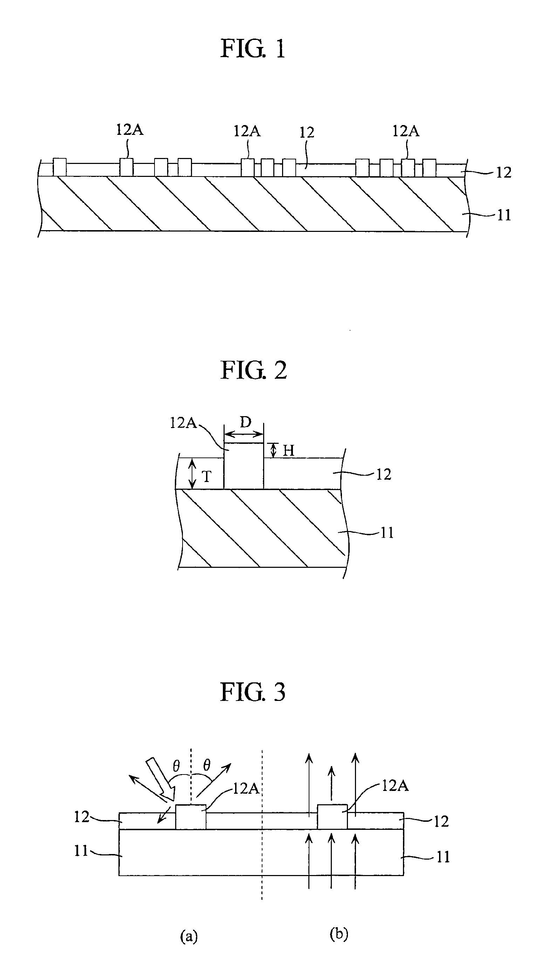

Fig. 1 is a partially schematic section view (central partial view) showing an example of a basic structure of the optical filter for display according to the present invention.

The optical filter for display according to the invention is basically composed of a transparent substrate 11 and an antiglare layer 12 formed on the transparent substrate 11. The antiglare layer 12 contains fine particles 12A which protrude from the surface of the antiglare layer 12. At the top portions of the protruded fine projections of the fine particles 12A, there are plain surfaces parallel to a surface of the antiglare layer other than the fine projections. In order to obtain excellent antiglare properties, not less than half of the plain surfaces of the fine projections of the fine particles 12A are required to be parallel to a surface of the antiglare layer as above.

The antiglare layer 12 of the invention can be advantageously obtained by coating a liquid including resin and polyhedron-shaped, preferably hexahedron-shaped fine particles dispersed in the resin. By the coating, the projections can be easily and stably formed such that the protruded degree of the projections is in a desired range, and therefore it is not required to precisely control the conditions for the coating. Thus an antiglare layer having desired antiglare properties can be formed in high productivity. The thickness of the antiglare layer is preferably in the range of 1 to 20µm, especially 1 to 15µm.

A partially enlarged section view of the optical filter for display of Fig. 1 is shown in Fig. 2. "T" represents the thickness of the antiglare layer 12. The fine particles 12A are buried in the antiglare layer 12 such that the fine particles 12A protrude from the antiglare layer 12 by a length of "H". The average height "H" of the fine projections is generally in the range of 0.5 to 5µm. Thereby, the resultant antiglare layer has excellent antiglare properties, high transmittance and improved visibility and contrast of image.

Sides "D" of the fine particles 12A have various lengths. However, when the fine particle is in the form of cubic, the sides "D" are one kind. The average length of the sides "D" is generally in the range of 0.1 to 10µm whereas the average particle size of the fine particles is generally in the range of 0.1 to 15µm. The protruded length "H" preferably corresponds to 10 to 50%, especially 10 to 40% of the average particle size. Hence, in case hard coat function is added to the antiglare layer, the projections do not impair the hard coat function and therefore the antiglare layer acquires excellent abrasion resistant and durability. Also the protruded length "H" preferably corresponds to 10 to 50%, especially 10 to 40% of the thickness of the antiglare layer. Thereby, in case hard coat function is added to the antiglare layer, the projections do not impair the hard coat function and therefore the antiglare layer acquires excellent abrasion resistant and durability.

In the optical filter of the invention of Fig. 1, incident light from outside (bold arrow) scatters on a surface of a rectangular-parallelepiped-shaped projection (concave portion) of the antiglare layer 12 provided on the transparent substrate 11, as shown in Fig. 3(a). In this case, obliquely incident light, which occupies almost of the incident light, scatters on the surface of the projection parallel to the surface of the substrate, for example, scatters at angle θ (especially θ = 30-60 degrees), whereas light incident on the side surface of the projection naturally scatters or reflects outward. Hence, occurrences of glare and of image generated by reflection are greatly repressed. On the other hand, as shown in Fig. 3(b), light emitted from inside is incident vertically on the surface of the projection parallel to the surface of the substrate, and therefore the light is almost brought to audience without scattering whereby transmittance and contrast are greatly enhanced.

The shape of the fine projection of the antiglare layer 12 is generally polyhedron, preferably hexahedron, particularly cube. Thereby more excellent antiglare properties, high transmittance and improved visibility (sharpness) and contrast of image can be easily obtained. In the invention, the fine projections are mainly formed from the fine particles as mentioned above. The antiglare layer is a resin layer including a resin and fine particles dispersed therein, and therefore the protruded projection is formed from the fine particle. However, an extremely thin layer of resin generally exists on the surface of the protruded projection. In general, the protruded projection is formed from 90% or more by weight of the fine particle.

The fine particles 12A are generally organic resin fine particles or inorganic fine particles. The organic resin fine particles are preferably at least one kind selected from cross-linked acrylic resin particles, cross-linked styrene resin particles and cross-linked (meth)acrylate-styrene copolymer particles. The inorganic fine particles are preferably at least one kind selected from calcium carbonate fine particles and silica fine particles. The fine particle is in the form of polyhedron. It is preferably in the form of hexahedron, further preferably rectangular parallelepiped, particularly in the form of cube. Thereby, the plain surfaces parallel to a surface of the antiglare layer other than the fine projections can be easily obtained.

The antiglare layer 12 preferably contains ultraviolet curable resin as resin. Thereby hard coat function can be easily given to the antiglare layer. Further a sealing layer preferably has the same composition as that of the antiglare layer, whereby the antiglare properties can be stably obtained and the productivity can be also enhanced.

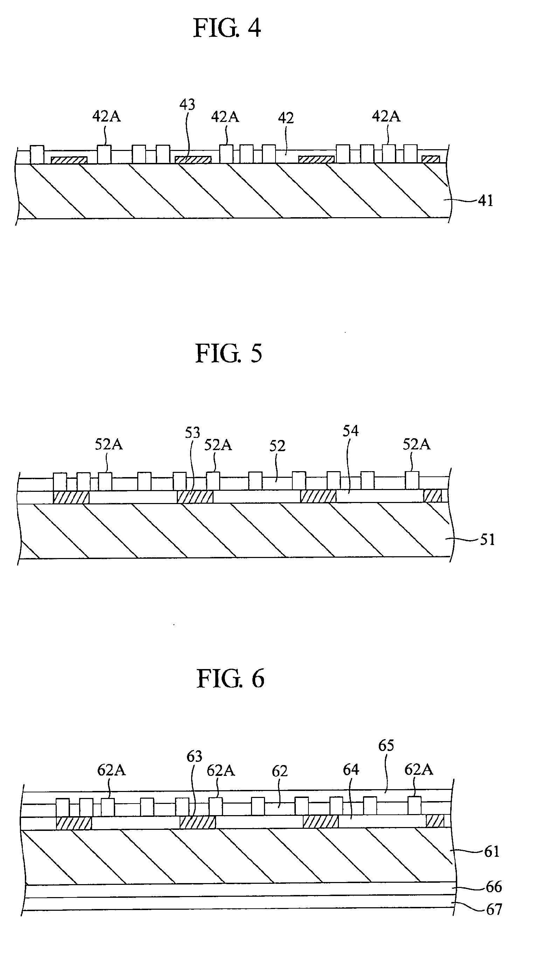

Fig. 4 is a partially schematic section view (central partial view) showing an example of preferred embodiments of the optical filter for display according to the present invention.

The optical filter for display of the invention is basically composed of a transparent substrate 41, an electrically conductive layer (electromagnetic wave shield layer) 43 formed on the transparent substrate 11 and an antiglare layer 42 formed on the conductive layer 43. The antiglare layer 42 is provided with fine projections having plain surfaces parallel to a surface of the antiglare layer other than the fine projections as above, and to this end, the antiglare layer 42 contains fine particles 42A which protrude from the surface of the antiglare layer 42. This structure is preferred in the case of the small thickness of mesh (conductive layer), for example thickness of not more than 5µm because the antiglare layer covers the mesh. In this embodiment, it is preferred that the thickness is 1µm or more larger than the height of the mesh of the conductive layer.

Fig. 5 is a partially schematic section view (central partial view) showing another example of preferred embodiments of the optical filter for display according to the present invention.

The optical filter for display of the invention is basically composed of a transparent substrate 51, an electrically conductive layer (electromagnetic wave shield layer) 53 formed on the transparent substrate 51, further a sealing layer 54 infilling the gaps between mesh of the conductive layer 53, and an antiglare layer 52 formed on the conductive layer 53 and sealing layer 54 (on the sealing layer 54 in the case the sealing layer 54 covers the conductive layer 53). The antiglare layer 52 is provided with fine projections having plain surfaces parallel to a surface of the antiglare layer other than the fine projections as above, and therefore the antiglare layer 52 contains fine particles 52A which protrude from the surface of the antiglare layer 52.

In this embodiment, the sealing layer 54 fills in the gaps between mesh of the conductive layer 53 whereby substantial plain surface is formed, and then the antiglare layer 52, which is such a thin layer that the fine particles 52A protrude from the layer, is provided. Even if the optical filter has the mesh-shaped conductive layer, the projections can be easily formed and the projection degree can be also easily controlled. When the sealing layer is provided, the thickness of the antiglare layer is preferably in the range of 1 to 8µm, especially 1 to 5µm.

The optical filter of the invention ensures sufficiently antiglare properties, transmittance, and visibility (sharpness) and contrast of image in high level. In more detail, as shown in Fig. 3 mentioned above, it is possible to reduce surface diffusion component in perpendicular direction generated from incident light (e.g., 30-60 degrees) of the antiglare layer. Thereby definition (visibility) of reflected image (reflected angle: 45 degrees) can be generally designed to be not more than 100, the definition being defined in JIS K 7105. SCE preferably is not more than 1.0 and glare value preferably is not more than 30. The SCE is measured value of reflected (diffused) component obtained by remove regular reflection component from incident light of 45 degrees, which is measure by the use of CM-2600d available from KONICA MINOLTA HOLDINGS, INC., and the glare value is measured under the condition of angle of 20 degrees by the use of PG-1M available from NIPPON DENSYOKU INDUSTRIES, CO., LTD according to JIS Z 874. Further in the invention, diffusion component of transmitted light of light incident on the antiglare layer from the substrate side is greatly reduced as shown in Fig. 3. Thereby definition (visibility) of transmitted image can be generally designed to be not less than 150, the definition being defined in JIS K 7105. Further haze value can be designed to be not more than 5%. In general, these measurements relating to visibility are carried out regarding a laminate consisting of a film and an antiglare layer (Fig. 1), or a laminate consisting of a film, a conductive layer and an antiglare layer (Fig. 4).

Fig. 6 is a partially schematic section view (central partial view) showing another example of preferred embodiments of the optical filter for display according to the present invention. The optical filter for display of the invention is basically composed of a transparent substrate 61, a mesh-shaped conductive layer 63 formed on one side of the transparent substrate 61, a sealing layer 64 on the conductive layer 63, an antiglare layer 62 containing fine particles 62A and a low refractive index layer 65 on the antiglare layer 62, and a near-infrared absorption layer 66 provided on the other side of the transparent substrate 61 and a transparent adhesive layer 67 on the near-infrared absorption layer 66. This structure is particularly suitable for a PDP filter.

In case the optical filter of the invention is used in PDP, it is preferred that an antiglare layer or each of the antiglare layer and other layer(s) such as a low refractive index layer thereon has an exposed area of conductive layer (generally obtained by removing its (their) edge area of the layer(s) by laser beam) in its (their) edge area, or has an exposed area of conductive layer and an antiglare layer or the antiglare layer and low refractive index layer which is provided outside the an exposed area of conductive layer.

The antiglare layer of the invention has generally excellent antireflection effect, and therefore provision of an antireflection layer is mostly not required. Hence, the provision of the antiglare layer enhances freedom degree with respect to selection of refractive index of other layers to broaden the options of materials of the layers, whereby reduction of cost can be also obtained. In case the optical filter has the antiglare layer and low refractive index layer, the combination brings about excellent antireflection effect compared with that of only antiglare layer.

The antiglare layer or the antiglare layer and low refractive index layer can be preferably formed by applying a coating liquid including resin, organic solvent and fine particles dispersed therein. In the application, it is preferred that structured components (e.g., mesh, undercoat, substrate) are not affected by the organic solvent and maintain high transparency.

Although an a near-infrared absorption layer and a transparent adhesive layer are provided in Fig. 6, a near-infrared absorption layer, a neon-cut layer or a transparent adhesive layer, or a combination of two more kinds thereof may be provided. Otherwise, it is also preferred that a transparent adhesive layer having near-infrared absorption function and neon-cut function is provided, or that a near-infrared absorption layer having neon-cut function and a transparent adhesive layer (which are formed on a transparent film in this order) are provided, or a near-infrared absorption layer, a neon-cut layer and a transparent adhesive layer (which are formed on a transparent film in this order) are provided.

The mesh-shaped conductive layer 63 of the invention is generally a mesh-shaped metal layer or a metal-containing layer. The mesh-shaped metal layer or metal-containing layer is generally formed by etching or printing, or is a metal fiber layer, whereby low resistance can be easily obtained. In general, gaps (voids) of the mesh-shaped metal layer or metal-containing layer are filled with the sealing layer 54, 64 as mentioned above, whereby transparency and antiglare properties are enhanced.

The low refractive index layer 65 constitutes a antireflection layer. In more detail, a composite film of an antiglare layer and a low refractive index layer provided thereon shows efficiently antireflection effect. Between the low refractive index layer and antiglare layer, a high refractive index layer may be provided, whereby antireflection effect is further enhanced.

Without provision of the low refractive index layer 65 and the like, only the transparent substrate and antiglare layer may be provided. The transparent substrate and antiglare layer are generally formed by coating method, which is preferred in view of productivity and economic efficiency.

The near-infrared absorption layer 66 has function shielding (cutting off) unnecessary lights such as neon light emitting of PDP. The layer generally contains a dye having absorption maximum in the wavelengths of 800 to 1200m. The transparent adhesive layer 67 is provided for easily attaching the optical filter to a display. A peeling layer may be provided on the transparent adhesive layer 67.

The optical filter for display of the invention is obtained, for example, by forming on a whole surface of a rectangle-shaped transparent substrate (generally transparent film), a mesh-shaped conductive layer, and then forming on the whole mesh-shaped conductive layer, an antiglare layer or a sealing layer and antiglare layer. If necessary, an antireflection layer having low refractive index layer is provided on the antiglare layer, and if necessary, the near-infrared absorption layer and the transparent adhesive layer are provided in this order on the reverse side of the transparent film. Thereafter, if necessary, electrode portion may be formed on the edges of whole circumference (four sides) of the antiglare layer by irradiating the edges with a laser.

The above-mentioned optical filter for display has one transparent film, but may have two transparent films. For example, a transparent film having an antiglare layer and an antireflection layer such as a low refractive index layer and having an adhesive layer provided on the reverse side is superposed on another transparent film having the mesh-shaped conductive layer through an adhesive agent such that the reverse side of the transparent film faces mesh-shaped conductive layer of the another transparent film, and bonded to each other through the adhesive layer, and if necessary by irradiating the antiglare layer and the antireflection layer such as the low refractive index layer with a laser. Otherwise, a mesh-shaped conductive layer, an antiglare layer and an antireflection layer such as a low refractive index layer are formed on an transparent film in this order, and a near-infrared absorption layer and a transparent adhesive layer are formed on another transparent film in this order, and then the two transparent films are bonded to each other such that the sides having no layer (reverse sides) of the films are in contact with each other. In this case, the former laminate is prepared according to the process of the invention.

Though the use of two transparent films is adopted when it is advantageous for the processing of preparation, it has disadvantage of increases of thickness and of volume.

Materials used in the optical filter for display of the present invention are explained below.
The transparent film is generally a transparent film, preferably a transparent plastic film. The materials may be anything having transparency (the transparency meaning transparency to visible light), a plastic film is generally used.
Examples of materials of the plastic film include polyester such as polyethylene terephthalate (PET) and polybutylene terephthalate, acrylic resin such as polymethyl methacrylate (PMMA), polycarbonate (PC), polystyrene, cellulose triacetate, polyvinyl alcohol, polyvinyl chloride, polyvinylidene chloride, polyethylene, ethylene-vinyl acetate copolymer, polyvinyl butyral, metal-crosslinked ethylene-methacrylic acid copolymer, polyurethane and cellophane. Preferred are polyethylene terephthalate (PET), polycarbonate (PC), polymethyl methacrylate (PMMA), because have high resistance to processing loads such as heat, solvent and bending and high transparency. Especially PET is preferred because of excellent processing properties. An inorganic plate such as glass plate may be used.

The transparent film has generally a thickness of 1µm to 10mm, preferably 1µm to 5mm, particularly 25 to 250µm depending upon the application of the optical filter.

The metal conductive layer of the invention is set such that surface resistance value of the resultant optical filter generally is not more than 10Ω/□, preferably in the range of 0.001 to 5Ω/□, especially in the range of 0.005 to 5Ω/□.

The conductive a layer of the invention preferably is a mesh-shaped (lattice-shaped) conductive a layer. As examples of the mesh-shaped conductive layer, a layer formed by processing metal fiber or metal-coated organic fiber in the form of net, a layer obtained by etching a metal (e.g., Cu) layer provided on a transparent film in the form of net so as to form mesh having openings, and a layer obtained by printing an electrically conductive ink on a transparent film so as to form mesh.

The mesh of the mesh-shaped conductive layer is generally composed of metal fiber and/or metal-coated organic fiber having line width of 1µm to 1mm and opening ratio of 40 to 95%. Further preferred is a mesh having line width of 10 to 500µm and opening ratio of 50 to 95%. In the mesh-shaped conductive layer, line width more than 1mm brings about enhanced electromagnetic wave shielding property, while opening ratio is reduced. Line width less than 1µm brings about reduction of the strength of the resultant mesh to render its handling difficult. Moreover, opening ratio more than 95% renders keeping of the shape of the mesh difficult, while opening ratio less than 40% brings about reductions of optical transparency to lower light amount from a display.

The opening ratio (aperture ratio) of the mesh-shaped conductive layer means the proportion of the area of the opening portion of the layer to the projected area of the layer.

As metals for the metal fiber and/or metal-coated organic fiber constituting the mesh-shaped conductive layer, copper, stainless, aluminum, nickel, titanium, tungsten, tin, lead, iron, silver, carbon, or alloys thereof, preferably copper, stainless or nickel is used.

As organic materials for the metal-coated organic fiber, polyester, nylon, vinylidene chloride, aramid, vinylon, cellulose is used.

In a patternwise etched conductive foil such as metallic foil, as metals for the metallic foil, copper, stainless, aluminum, nickel, iron, brass or alloys thereof, preferably copper, stainless or aluminum is used.

In case of decreasing the thickness of the metal foil to excess, handling of the foil and workability of pattern etching are reduced. In case of increasing the thickness to excess, a thickness of the resultant filter is increased and time period requiring for etching procedure is lengthened.
Therefore the thickness of the conductive layer preferably is in the range of 1 to 200 µm.

The etched pattern may have any shapes. For example, the metallic foil is in the form of lattice, which is obtained by forming square openings (pores) on the foil, or in the form of punching metal, which is obtained by forming circle, hexagon, triangle or ellipse openings. The openings may be regularly arranged or irregularly arranged to have a random pattern. The opening ratio (the proportion of the area of the opening portion to the projected area) of the metal foil is preferably in the range of 20 to 95%. It is preferred that the line width is 1µm to 1mm and opening ratio is 40 to 95%, and further preferred that the line width is 10 to 500µm and the opening ratio is 50 to 95%.

Besides above, material soluble in a solvent is dot-wise applied to a film to form dots, a conductive material layer insoluble in the solvent is formed on the film, and the film is brought in contact with the solvent to remove the dots and the conductive material layer provided on the dots whereby a mesh-shaped metal conductive layer can be obtained. The mesh-shaped metal conductive layer may be used in the invention.

A plated layer (metallic deposit) may be further provided on the metal conductive layer in order to enhance conductive property. Particularly, it is preferred to form the plated layer on the layer obtained by the formation of dots using material soluble in a solvent. The plated layer can be formed by conventional electrolytic plating and nonelectrolytic plating. Examples of metals used in the plating generally include copper, copper alloy, nickel, aluminum, silver, gold, zinc or tin. Preferred is copper, copper alloy, silver or nickel, particularly copper or copper alloy is preferred in view of economic efficiency and conductive property.

Further antiglare property may be provided to the conductive layer. In a step of the antiglare treatment, a blackened treatment may be carried out on a surface of the (mesh-shaped) conductive layer. For example, oxidation treatment of metal layer, black plating of chromium alloy, or application of black or dark color ink can be carried out.

As the conductive layer of the invention, known conductive layer such as a thin metal layer or a transparent conductive layer of metal oxide such as ITO can be used instead of the mesh-shaped conductive layer.

The antiglare layer of the invention is generally composed chiefly of resin such as acrylic resin, epoxy resin, urethane resin and/or silicon resin and fine particles in the form of polyhedron. The antiglare layer has generally a thickness of 1 to 20µm, preferably 1 to 15µm. A part of the fine particle is protruded from the surface of the antiglare layer. The top portion of the protruded part (convex portion) has a plain surface parallel to a surface of the substrate (antiglare layer) and therefore the shape of the convex portion is generally polyhedron, preferably rectangular parallelepiped, particularly cube.

The resin is generally thermosetting resin, ultraviolet curable resin, preferably ultraviolet curable resin. The ultraviolet curable resin is preferred because it can be cured for a short time to bring about excellent productivity and easily removed with a laser.

Examples of the thermosetting resin include phenol resin, resorcinol resin, urea resin, melamine resin, epoxy resin, acrylic resin, urethane resin, furan resin and silicon resin.

The antiglare layer preferably is a cured layer of an ultraviolet curable resin composition, which comprises ultraviolet curable resin, photopolymerization initiator, etc.

Examples of the ultraviolet curable resin (comprising monomers, oligomers, etc.) include (meth)acrylate monomers such as 2-hydroxyethyl (meth)acrylate, 2-hydroxyropyl (meth)acrylate, 4-hydroxybutyl (meth)acrylate, 2-ethylhexylpolyethoxy (meth)acrylate, benzyl (meth)acrylate, isobornyl (meth)acrylate, phenyloxyethyl (meth)acrylate, tricyclodecane mono(meth)acrylate, dicyclopentenyloxyethyl (meth)acrylate, tetrahydrofurfuryl (meth)acrylate, acryloylmorpholine, N-vinylcaprolactam, 2-hydroxy-3-phenyloxypropyl (meth)acrylate, o-phenylphenyloxyethyl (meth)acrylate, neopentylglycol di(meth)acrylate, neopentyl glycol dipropoxy di(meth)acrylate, neopentyl glycol hydroxypivalate di(meth)acrylate, tricyclodecanedimethylol di(meth)acrylate, 1,6-hexanediol di(meth)acrylate, nonanediol di(meth)acrylate, trimethylolpropane tri(meth)acrylate, pentaerythritol tri(meth)acrylate, pentaerythritol tetra(meth)acrylate, tris[(meth)acryloxyethyl]isocyanurate and ditrimethylolpropane tetra(meth)acrylate; and the following (meth)acrylate oligomer such as:
polyurethane (meth)acrylate such as compounds obtained by reaction among the following polyol compound and the following organic polyisocyanate compound and the following hydroxyl-containing (meth)acrylate:
the polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1,3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol with polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol with ε-caprolactone; a compound obtained by reaction of the above-mentioned polyol and a reaction product of the above-mentioned polybasic acid or anhydride thereof and ε-caprolactone; polycarbonate polyol; or polymer polyol), and
the organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4-trimethylhexamethylene diisocyanate), and
the hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono(meth)acrylate, pentaerythritol tri(meth)acrylate or glycerol di(meth)acrylate);
bisphenol-type epoxy(meth)acrylate obtained by reaction of bisphenol-A epoxy resin or bisphenol-F epoxy resin and (meth)acrylic acid.
   These compounds can be employed singly or in combination of two or more kinds. The ultraviolet curable resin can be used together with thermo polymerization initiator, i.e., these can be employed as a thermosetting resin.

To give hard coat function to the antiglare layer, hard polyfunctional monomer such as pentaerythritol tri(meth)acrylate, pentaerythritol tetra(meth)acrylate, and dipentaerythritol hexa(meth)acrylate, is preferably used in a main component.

Photopolymerization initiators can be optionally selected depending upon the properties of the ultraviolet curable resin used. Examples of the photopolymerization initiators include acetophenone type initiators such as 2-hidroxy-2-methyl-1-phenylpropane-1-on, 1-hydroxycyclohexylphenylketone and 2-methyl-1-[4-(methylthio)phenyl]-2-morphorino-propane-1-on; benzoin type initiators such as benzylmethylketal; benzophenone type initiators such as benzophenone, 4-phenylbenzophenone and hydroxybenzophenone; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone,
2-methyl-1-[4-(methylthio)phenyl]-2-morphorinopropane-1-on and benzophenone. These photopolymerization initiators can be employed together with one or more kinds of a conventional photopolymerization promoter such as a benzoic acid type compound (e.g., 4-dimethylaminobenzoic acid) or a tertiary amine compound by mixing with the promoter in optional ratio. Only the initiator can be employed singly or in combination of two or more kinds. Especially, 1-hydroxycyclohexylphenylketone (Irgercure 184, available from Chiba-Specialty Chemicals) is preferred.

The initiator is preferably contained in the resin composition in the range of 0.1 to 10% by weight, particularly 0.1 to 5% by weight based on the resin composition.

The antiglare layer of the invention generally contains fine particles in the form of polyhedron. The fine particles generally are inorganic fine particles or organic resin fine particles. The organic resin fine particles are preferred in view of excellent transparency. Examples of the organic resin fine particles include cross-linked acrylic resin fine particles, cross-linked styrene resin fine particles and cross-linked (meth)acrylate-styrene copolymer fine particles. Examples of the inorganic fine particles include inorganic pigments such as calcium carbonate, silica, bentonite, kaolin; and metal oxides such as ITO, TiO₂ ZrO₂, CeO₂, SiO₂, Al₂O₃, Y₂O₃, La₂O₃, LaO₂, and Ho₂O₃. Preferred are cross-linked calcium carbonate, silica, acrylic resin fine particles, particularly calcium carbonate because the calcium carbonate having cubic crystal of calcite. The fine particles can be employed singly or in combination of two or more kinds. The fine particles preferably has refractive index near to that of the resin of the antiglare layer. The difference between refractive index of the fine particles and that of the resin preferably is not more than 0.2.

The shape of the fine particle is any shape having at least one plain surface, i.e., any shape except that the shape has at least one plain surface. However, in order to form projections having a plain surface by coating method, the shape generally is tetra- to octadeca-hedron, preferably hexahedron. The tetragon of each surface (face) of the hexahedron is any of rectangle, square (regular tetragon), or parallelogram. Further, the shape of the fine particle preferably is substantially rectangular parallelepiped, particularly substantially cube.

The fine particle preferably has average particle size of 0.5 to 15µm, particularly 0.5 to 10µm. The particle size of less than 0.5µm brings about satisfactory antiglare effect because the protruded portion of the particle from the antiglare layer is reduced. In contrast, the particle size of more than 15µm brings about reduction of visibility (legibility). The fine particle is generally used in the amount of 0.1 to 10% by weight, preferably 0.1 to 5% by weight based on a resin composition for forming the antiglare layer.

The antiglare layer may further contain an ultraviolet absorber, an aging resistant agent, a processing auxiliary agent for paint and a dye, in a small amount. Particularly the layer preferably contains the ultraviolet absorber (e.g., benzotriazole ultraviolet absorber, or benzophenone ultraviolet absorber), whereby yellowing of the optical filter can be efficiently prevented. The amount generally is in the range of 0.1 to 10% by weight, preferably 0.1 to 5% by weight based on the resin composition.

The sealing layer 54, 64 which is provided under the antiglare layer preferably is the same layer as the antiglare layer, or a layer composed chiefly of the resin used in the antiglare layer (i.e., antiglare layer containing no particles). In particular, the sealing layer preferably is the same layer as the antiglare layer whereby ensures stable antiglare properties and enhanced productivity.

The thickness of the antiglare layer corresponds substantially to the thickness (height) of the mesh of the conductive layer because it is required to fit the gaps of the mesh.

The antiglare layer (and the sealing layer) preferably has lower refractive index than that of the transparent substrate. The use of the ultraviolet curable resin easily brings about the lower refractive index. Hence, it is preferred that materials having high refractive index such as PET is used as materials of the transparent substrate. Therefore the antiglare layer preferably has refractive index of not more than 1.60. The thickness is mentioned above.

The low reflective index layer, which is provided on the antiglare layer, preferably is a layer (cured layer) in which particles of silica or fluorine resin (preferably hollow silica) are dispersed in polymer (preferably ultraviolet curable resin). The low reflective index layer contains preferably 10 to 40 % by weight, especially 10 to 30% by weight of the particles. The low reflective index layer preferably has refractive index of 1.45 to 1.51. The refractive index of more than 1.51 brings about reduction of antireflection properties of the antireflection layer. The thickness generally is in the range of 10 to 500µm, preferably 20 to 200nm.

The hollow silica preferably has mean particle size of 10 to 100µm, especially 10 to 50nm, and specific gravity 0.5 to 1.0, especially 0.8 to 0.9.

In order to enhance antireflection properties, the high reflective index layer may be provided under the low refractive index layer. The high reflective index layer is preferably a layer (cured layer) in which conductive metal oxide particles (inorganic compound) such as ITO, ATO, Sb₂O₃, SbO₂, In₂O₃, SnO₂, ZnO, Al-doped ZnO, TiO₂ are dispersed in polymer (preferably ultraviolet curable resin). The conductive metal oxide particle generally has mean particle size of 10 to 10,000nm, preferable 10 to 50nm. Especially ITO (especially mean particle size of 10 to 50nm) is preferred. The high reflective index layer preferably has refractive index of not less than 1.64. The thickness generally is in the range of 10 to 500nm, preferably 20 to 200nm.

In case the high reflective index layer has a conductive layer, the minimum reflectivity of the surface of the antireflection layer can be reduced to not more than 1.5% by increasing the refractive index of the high reflective index layer to not less than 1.64. Further the minimum reflectivity of the surface of the antireflection layer can be reduced to not more than 1.0% by preferably increasing the reflective index of the high reflective index layer as not less than 1.69, especially 1.69 to 1.82.

The provision of each of the antiglare layer, the sealing layer and the antireflection layer such as a low reflective index layer can be carried out, for example, by mixing polymer (preferably ultraviolet curable resin) with if desired the above-mentioned particles, and applying the resultant coating liquid onto the conductive layer of the transparent film provided with the conductive layer, and then drying and subsequently exposing to ultraviolet rays to be cured. The layers may be applied and cured, respectively, or all the layers may be applied and then cured at one time.

The application can be carried out, for example, by applying a coating liquid (solution) of ultraviolet curable resin including acrylic monomers in a solvent such as toluene by means of gravure coater, and drying, and then exposing to UV rays to cure. This wet-coating method enables high-speed, uniform and cheap film formation. After the coating, for example, the coated layers are exposed to UV rays to be cured whereby the effects of improved adhesion and enhanced hardness of the layer can be obtained.

In the UV- rays curing, it is possible to adopt, as light source used, various sources generating light in the wavelength range of ultraviolet to visible rays. Examples of the sources include super-high-pressure, high-pressure and low-pressure mercury lamps, a metal halide lamp, a chemical lamp, a xenon lamp, a halogen lamp, a mercury halogen lamp, a carbon arc lamp, and an incandescent electric lamp, and laser beam. The exposing time is generally carried out in the range of a few seconds to a few minutes, depending upon kinds of lamp and strength of light. To promote the curing, the laminate may be heated beforehand for 40 to 120°C, and then the heated laminate may be exposed to ultraviolet rays.

The near-infrared absorption layer is generally obtained by forming a layer containing dye on a surface of the transparent film. The near-infrared absorption layer is, for example, prepared by applying a coating liquid containing dye and ultraviolet- or electron-beam- curable resin containing binder resin, if desired drying and curing the applied layer, or applying a coating liquid containing dye and thermosetting resin, if desired drying and curing the applied layer. Otherwise, the near-infrared absorption layer is, for example, prepared by applying a coating liquid containing dye and binder resin and drying. When the near-infrared absorption layer is used as a film, it is generally a near-infrared cut film, such as dye-containing film. The dye generally has absorption maximum in wavelength of 800 to 1200nm, and its examples include phthalocyanine dyes, metal complexes dyes, nickel dithioren complexes dyes, cyanine dyes, squalirium dyes, polymethine dyes, azomethine dyes, azo dyes, polyazo dyes, diimmonium dyes, aminium dyes, anthraquinone dyes. Preferred are cyanine dyes, phthalocyanine dyes and diimmonium dyes. These dyes can be employed singly or in combination. Examples of the binder resin include thermoplastic resin such as acrylic resin.

In the invention, a neon-emission absorption function may be given to the near-infrared absorption layer such that the near-infrared absorption layer has function for adjusting color hue. For this purpose, a neon-emission absorption layer may be provided. However, the near-infrared absorption layer may contain a neon-emission selective absorption dye.

Examples of the neon-emission selective absorption dyes include cyanine dyes, squalirium dyes, anthraquinone dyes, phthalocyanine dyes, polymethine dyes, polyazo dyes, azulenium dyes, diphenylmethane dyes, triphenylmethane dyes. The neon-emission selective absorption dyes are required to have neon-emission selective absorption function at wavelength of approx. 585nm and small absorption in a wavelength range of visible light except the wavelength. Hence, the dyes preferably have absorption maximum wavelength of 575 to 595nm, and half bandwidth of absorption spectrum of 40nm or less.

In case a plurality of absorption dyes including dyes for absorbing near-infrared light and dyes for absorbing neon emission light are used, if there are difficulties in terms of solubility of the dyes, if there are undesirable reactions among the mixed dyes, and if there is deterioration of thermal resistance or moisture resistance, it is not necessary for all the absorption dyes to be contained in the same layer, and the absorption dyes may be contained in different layers in such a case.

Further, coloring materials, ultraviolet absorbers, and antioxidants may be added as long as those materials adversely affect the optical properties of the filter.

As the near-infrared absorption properties of the optical filter of the invention, the transmittance of light in a wavelength range of 850 to 1000 nm preferably is 20% or lower, more preferably, 15% or lower. As the selective absorption properties of the optical filter, the transmittance of light at a wavelength of 585 nm preferably is 50% or lower. In the former, a transmittance of light existing in the following wavelength range can be reduced, the wavelength range being thought to be a cause of malfunction of remote control systems in peripheral devices. In the latter, though orange light having peak wavelength in the range of 575 to 595 nm deteriorates color reproductivity, the wavelength of orange light can be absorbed whereby red light is rendered more intrinsic and as a result, reproducibility of colors can be improved.

The near-infrared absorption layer generally has thickness of 0.5 to 50µm.

In case a conductive adhesive tape is attached onto the exposed area of the metal conductive layer, as the conductive adhesion tape, a tape having a metal foil and an adhesion layer containing electrically conductive particle dispersed in the layer provided on one side of the foil can be used. For forming the adhesion layer, adhesives such as acrylic adhesive, rubber adhesive and silicone adhesive, or epoxy resin or phenol resin containing hardening agent can be used.

As the electrically conductive particle, any materials showing good electrical conductivity can be used. Examples include metallic powder such as copper, silver, nickel powder, and resin or ceramic powder coated with the metal. Further the shape of the electrically conductive particle is also not restricted. Optional shape such as scale, arborization, grain, and pellet can be adopted.

The electrically conductive particle is generally used in the amount of 0.1 to 15% by volume based on polymer of the adhesion layer, and the mean particle size preferably is in the range of 0.1 to 100µm. The use of the particle specified in the used amount and particle size brings about prevention of aggregation of the conductive particles to provide good conductivity.

As the metallic foil as substrate of the conductive adhesive tape, a foil of metal such as copper, silver, nickel, aluminum, stainless can be used. The thickness generally is in the range of 1 to 100µm.

The adhesion layer can be easily formed by applying a mixture of the adhesive and the conductive particle in a predetermined ratio onto the metal foil by means of roll coater, die coater, knife coater, mica bar coater, flow coater, spray coater.

The thickness of the adhesion layer generally is in the range of 5 to 100µm.

Instead of the conductive adhesion tape, an adhesive made of materials constituting the adhesion layer mentioned above may be applied to the exposed area of the metal conductive layer, and a conductive tape (metal foil) may be attached to the adhesive.

The transparent adhesive layer of the invention is used to bond the optical filter of the invention to a display, and therefore any resin having adhesion function can be used as materials for forming the transparent adhesive layer. Examples of the materials include acrylic adhesives made of butyl acrylate and the like, rubber adhesives, TPE (thermoplastic elastomer) adhesives comprising as main component TPE such as SEBS (styrene/ethylene/butylene/styrene) and SBS (styrene/ butadiene/styrene).

The thickness of the transparent adhesive layer generally is in the range of 5 to 500µm, preferably in the range of 10 to 100µm. The optical filter can be generally attached to a glass plate of a display through the transparent adhesive layer.

In case of using two transparent films in the invention, examples of materials (adhesives) used in the adhesion of the films include ethylene/vinyl acetate copolymer, ethylene/methyl acrylate copolymer, acrylic resin (e.g., ethylene/(meth)acrylic acid copolymer, ethylene/ethyl (meth)acrylate copolymer, ethylene/methyl (meth)acrylate copolymer, metal-ion crosslinked ethylene/(meth)acrylic acid copolymer), and ethylene copolymers such as partially saponified ethylene/vinyl acetate copolymer, carboxylated ethylene/vinyl acetate copolymer, ethylene/(meth)acrylic acid/maleic anhydride copolymer, ethylene/vinyl acetate/(meth)acrylate copolymer. The (meth)acrylic acid means acrylic acid and methacrylic acid and the (meth)acrylate means acrylate and methacrylate. Besides these polymers, there can be mentioned polyvinyl butyral (PVB) resin, epoxy resin, phenol resin, silicon resin, polyester resin, urethane resin, rubber adhesives, thermoplastic elastomer (TPE) such as SEBS (styrene/ethylene/butylene/styrene) and SBS (styrene/butadiene/styrene). The acrylic adhesives and epoxy resins are preferred because they show excellent adhesion.

The thickness of the above-mentioned adhesive layer generally is in the range of 10 to 50µm, preferably in the range of 20 to 30µm. The optical filter can be generally attached to a glass plate of a display through the adhesive layer by application of pressure and heat.

A protective layer may be provided on the antireflection layer such as a low refractive index layer. The protective layer is preferably formed in the same manner as in the hard coat layer.

Materials for the release sheet provided on the transparent adhesive layer is generally transparent polymers having glass transition temperature of not less than 50°C. Examples of the materials include polyester resin (e.g., polyethylene terephthalate, polycyclohexylene terephthalate, polyethylene naphthalate), polyamide (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed. The thickness is generally in the range of 10 to 200µm, especially in the range of 30 to 100µm.

A schematic section view showing an example of the condition that the optical filter is attached onto an image display surface of a plasma display panel as one kind of display is shown in Fig. 7. The optical filter is attached onto the image display surface of the plasma display panel 70 through the transparent adhesive layer 77. In more detail, the optical filter is provided on the image display surface of the plasma display panel 70, the optical filter having a structure that a mesh-shaped metal conductive layer 73, a sealing layer 74, an antiglare layer 72 and an antireflection layer 75 such as a low refractive index layer are provided on one surface of a transparent film 71 in this order, and a near-infrared absorption layer 76 and a transparent adhesive layer 77 are provided on the other surface of the transparent film 71 in this order. Further, a mesh-shaped metal conductive layer 73' is exposed in an edge area (edge area of side) of the filter. The exposed mesh-shaped metal conductive layer 73' is in contact with a metallic cover 79 provided on a periphery of the plasma display panel 70 through a shield finger (leaf-spring shaped metal part) 78. A conductive gasket may be used instead of the shield finger. Hence, conduction between the optical filter and the metallic cover 79 can be attained to bring about grounded condition. The metallic cover 79 may be metal rack or frame. As apparent from Fig. 7, the mesh-shaped metal conductive layer 73 is directed to viewing audience. The metallic cover 79 covers the range of from the farthest edge of the metal conductive layer 73 to 2-20mm from the farthest edge. Otherwise, the shape of the metallic cover 79 is altered whereby the metallic cover 79 may be brought directly in contact with the metal conductive layer 73.

In PDP of the invention, since the optical filter generally has a plastic film as a substrate, it is possible to directly attach the optical filter to the surface of the glass plate of the PDP. Therefore, PDP itself can be reduced in weight, thickness and cost, especially in case of using one transparent film. Further, compared with PDP having a front plate of a transparent molded body in front of the PDP, PDP provided with the optical filter of the invention enables the removal of an air layer between PDP and a filter for PDP and hence resolves the increase of visible-rays reflectivity caused by the interface reflection and the occurrence of the double reflection. Thereby PDP of the invention can be improved in legibility. Furthermore, the optical filter of the invention has excellent antiglare properties, high transmittance and improved visibility and contrast of image, and therefore PDP provided with the filter displays image improved in antiglare properties, transmittance, visibility and contrast.

Thus, the display provided with the optical filter of the invention has excellent antireflection property and antistatic property, and generates little radiation of dangerous electromagnetic wave, and further is easily viewable, and free from dust attachment.

### EXAMPLE

The invention is illustrated in detail using the following Examples and Comparative Example. The invention is not restricted by the following Examples.

### [Comparative Example 1]

### <Preparation of optical filter for display>

### (1) Formation of antiglare layer

The following formation:

| | |
|---|---|
| Dipentaerythritol hexaacrylate | |
| (NK ester A-TMM-3L, available from | |
| Shin-Nakamura Chemical Co., Ltd.) | 200 weight parts |
| Acrylic beads (Shape: spherical shape, | |
| Mean particle size: 1.9µm, Refractive index: 1.49, | |
| Trade name: MX-180TA, available from | |
| Soken Chemical & Engineering Co., Ltd.) | 3 weight parts |
| IPA | 100 weight parts |
| Cyclohexanone | 100 weight parts |
| Irgacure 184 | |
| (Available from Ciba specialty chemicals) | 6 weight parts |

was mixed to form a coating liquid, which was applied onto a whole surface of an adhesive layer (polyester-polyurethane, thickness: 20nm) of a continuous polyethylene terephthalate film (thickness: 100µm, width: 600mm, length: 100m) provided with the adhesive layer, and cured by UV irradiation. Hence, an antiglare layer having thickness of 1.5µm (refractive index: 1.48) was formed on the adhesive layer of the continuous polyethylene terephthalate film.

Thus an optical filter for display ware prepared.

### [Example 1]

In Comparative Example 1, an optical filter for display was prepared by using calcium carbonate beads (Shape: cubic shape, Mean particle size: 1.8µm, Refractive index: 1.55-1.60, Trade name: CUBE-18BHS, available from MARUO CALCIUM CO., LTD.) instead of the acrylic beads in the same amount.
The resultant antiglare layer had a thickness of 1.4µm. The antiglare layer had fine projections whose top portions had a plain surface parallel to a surface of the antiglare layer other than the fine projections by transmission electron microscope observation.

### [Evaluation of optical filter]

(1) Average length of sides of a plain surface parallel to a surface of an antiglare layer other than fine projections, and average height of fine projections
   The average length of the sides of the plain surface parallel to a surface of the antiglare layer other than the fine projections and the average height of the fine projections are determined from the profile curve (sectional curve) which is obtained by measuring the surface of the antiglare layer by using a surface roughness meter (Trade name: SURFCOM 480A; available from TOKYO SEIMITSU CO. LTD.) according to JIS B 0601-2001. The measured length is 2m.
(2) Definition of transparent image
   The definition (visibility) of transparent image is determined according to JIS K 7105. The used measuring instrument is an image clarity instrument (ICM-1, Suga Test Instruments Co.,Ltd.).
(3) Definition of reflected image (reflected angle: 45 degrees)
   The definition (visibility) of reflected image (reflected angle: 45 degrees) is determined according to JIS K 7105. The used measuring instrument is an image clarity instrument (ICM-1, Suga Test Instruments Co.,Ltd.).
(4) Haze of optical filter
   The haze value is determined by using a turbidimeter (NDH2000, NIPPON DENSHOKU INDUSTRIES CO.,LTD.) according to the measuring method described in JIS K 7105 (1981).
(5) SCE of optical filter
   The SCE is determined by using CM-2600d available from KONICA MINOLTA HOLDINGS, INC.

The obtained results were shown in Table 1.

**Table 1**

| | Mean particle size of fine particles | Height of projection (Proportion of pro-trusion to particle size of fine particles) | Definition of transparent image | Definition of reflected image | Haze (%) | SCE |
|---|---|---|---|---|---|---|
| Co. Ex. 1 | 1.9µm | 0.4µm (21%) | 170 | 56 | 3.4 | 1.2 |
| Example 1 | 1.8µm | 0.38µm (21%) | 223 | 69.7 | 2.5 | 0.68 |

The optical filter obtained in Example 1 is excellent in definition of transparent image, definition of reflected image and haze compared with the filter of Comparative Example 1. Thus the optical filter of Example 1 has excellent contrast of image.

An optical filter provided with additional function layers obtained by giving the additional function layers to the optical filter of Example 1 was prepared as follows:

### [Example 2]

### <Preparation of optical filter for display>

Onto a whole surface of an adhesive layer (polyester-polyurethane, thickness: 20nm) of a continuous polyethylene terephthalate film (thickness: 100µm, width: 600mm, length: 100m) provided with the adhesive layer, a copper foil having thickness of 3µm was attached. The copper foil was subjected to photolithographic method to form a dot pattern and an exposed area of the copper foil was etched, whereby a copper foil in the form of mesh pattern was formed.

Thus line width of the conductive layer (copper layer) was 30µm, the pitch was 127µm, and the opening ratio is 58%. The mean thickness of the conductive layer (copper layer) was 3µm.

On the conductive layer, an antiglare layer of Example 1 was formed in the same manner as in Example 1.

### (2) Formation of low refractive index layer

The following composition:

| | |
|---|---|
| Opster JN-7212 (Available from JSR) | 100 weight parts |
| Methyl ethyl ketone | 117 weight parts |
| Methyl isobutyl ketone | 117 weight parts |

was mixed to form a coating liquid, which was applied onto a surface of the antiglare layer with a bar coater, and dried in an oven at 80°C for five minutes, and then cured by UV irradiation. Hence, a low refractive index layer having thickness of 90nm (refractive index: 1.42) was formed on the antiglare layer.

### (3) Formation of near-infrared absorption layer (having color hue adjusting function)

The following composition:

| | |
|---|---|
| Polymethyl methacrylate TAP-2 | 30 weight parts |
| (available from Yamada Chemical Co., Ltd.) Plast Red 8330 | 0.4 weight part |
| (available from Arimoto Chemical Co., Ltd.) CIR-1085 | 0.1 weight part |
| (available from Japan Carlit Co., Ltd.) IR-10A | 1.3 weight part |
| (available from Nippon Syokubai Co., Ltd.) | 0.6 weight part |
| Methyl ethyl ketone | 152 weight parts |
| Methyl isobutyl ketone | 18 weight parts |

was mixed to form a coating liquid, which was applied onto the reverse side of the PET film with a bar coater, and dried in an oven at 80°C for five minutes. Hence, a near-infrared absorption layer provided with color hue adjusting function having thickness of 5µm was formed on the reverse side of PET film.

### (4) Formation of adhesive layer

The following composition:

| | |
|---|---|
| SK Dyne 1811L (Available from Soken Chemical & Engineering Co., Ltd.) | 100 weight parts |
| Hardener L-45 (Available from Soken Chemical & Engineering Co., Ltd.) | 0.45 weight part |
| Toluene | 15 weight parts |
| Ethyl acetate | 4 weight parts |

was mixed to form a coating liquid, which was applied onto the near-infrared absorption layer with a bar coater, and dried in an oven at 80°C for five minutes. Hence, a transparent adhesive layer having thickness of 25µm was formed on the near-infrared absorption layer.

Thus, an optical filter for display was obtained.

The optical filter for display obtained in Example 2 was attached to PDP, and an image was produced on the PDP. Good image was obtained.

### [Industrial applicability]

The optical filter for display of the invention shows excellent antiglare properties, transparency and the like in image displayed on a display. Therefore the optical filter for display of the invention is particularly useful as a filter attached to various displays such as plasma display panel (PDP), organic EL (electroluminescence) display.

## Claims

1. An optical filter for display comprising a structure that an antiglare layer comprising a resin and fine particles dispersed therein is provided on one surface of a transparent substrate,
wherein a surface of the antiglare layer has a great number of fine projections formed from the fine particles and at least a part of the fine projections have a plain surface parallel to a surface of the antiglare layer other than the fine projections at their top portions.

2. An optical filter for display as defined in claim 1, wherein each of the projections is in the form of polyhedron.

3. An optical filter for display as defined in claim 2, wherein each of the projections is in the form of hexahedron.

4. An optical filter for display as defined in claim 3, wherein each of the projections is in the form of cube.

5. An optical filter for display as defined in any of claims 1 to 4,
wherein the plain surface parallel to a surface of the antiglare layer other than the fine projections has sides having an average length of 0.5 to 10µm.

6. An optical filter for display as defined in any of claims 1 to 5,
wherein the fine projections has an average height of 0.5 to 5µm.

7. An optical filter for display as defined in any of claims 1 to 6,
wherein the fine particles are organic resin fine particles and/or inorganic fine particles.

8. An optical filter for display as defined in any of claims 1 to 7,
wherein each of the fine particles is in the form of polyhedron.

9. An optical filter for display as defined in claim 8, wherein each of the fine particles is in the form of hexahedron.

10. An optical filter for display as defined in claim 9, wherein each of the fine particles is in the form of cube.

11. An optical filter for display as defined in any of claims 1 to 10,
wherein the fine particles have an average particle size of 0.5 to 15µm.

12. An optical filter for display as defined in any of claims 1 to 11,
wherein the antiglare layer has a thickness of 1 to 20µm.

13. An optical filter for display as defined in any of claims 1 to 12,
wherein the antiglare layer contains ultraviolet curable resin as resin.

14. An optical filter for display as defined in any of claims 1 to 13,
wherein an electrically conductive layer is provided between the antiglare layer and the transparent substrate.

15. An optical filter for display as defined in claim 14, wherein the conductive layer is a mesh-shaped conductive layer.

16. An optical filter for display comprising a structure that an antiglare layer comprising a resin and fine particles dispersed therein is provided on one surface of a transparent substrate,
wherein at least a part of the fine particles are in the form of hexahedron.

17. An optical filter for display as defined in claim 16, wherein the fine particles have an average particle size of 0.5 to 15µm.

18. An optical filter for display as defined in claim 16 or 17, wherein the conductive layer is a mesh-shaped conductive layer.

19. A display provided with the optical filter for display as defined in any of claims 1 to 18.

20. A plasma display panel provided with the optical filter for display as defined in any of claims 1 to 18.
